# EUROPÄISCHE PATENTSCHRIFT

(11) **EP 0 835 287 B1**
(45) Veröffentlichungstag und Bekanntmachung des Hinweises auf die Patenterteilung: **25.10.2000**
(21) Anmeldenummer: 96915973.0
(22) Anmeldetag: 05.06.1996
(51) Int. Cl.: C08L 63/00, C08K 9/06, H01B 3/40, C08K 3/00

(54) **VERWENDUNG VON SILICON-MODIFIZIERTEN EXPOXIDHARZEN ALS VERGUSSMASSE**
USE OF SILICONE-MODIFIED EPOXY RESINS AS POTTING COMPOUND
UTILISATION DE RESINES EPOXY MODIFIEES AU SILICONE COMME MASSES DE SCELLEMENT

(30) Priorität: 30.06.1995 DE 19523897
(43) Veröffentlichungstag der Anmeldung: 15.04.1998
(73) Patentinhaber: ROBERT BOSCH GMBH, 70442 Stuttgart (DE)
(72) Erfinder: PFANDER, Werner, D-70734 Fellbach (DE); JENNRICH, Irene, D-71364 Winnenden (DE); SPITZ, Richard, D-72766 Reutlingen (DE); KÖHLER, Uwe, D-71686 Remseck (DE); SCHULER, Siegfried, D-72829 Engstingen (DE)
(86) Internationale Anmeldenummer: DE9600993
(87) Internationale Veröffentlichungsnummer: WO9702321

(56) Entgegenhaltungen:
- EP-A- 0 673 957
- DE-A- 1 745 545
- US-A- 4 701 482

## Beschreibung

Es ist bekannt, Vergußmassen auf Basis von Epoxidharzen zur Einkapselung oder Beschichtung von elektrischen oder elektronischen Bauteilen zu verwenden. Als Beispiele für für derartige Bauteile seien Hochspannungszündspulen, elektronische Schaltkreise oder Halbleiterelemente, wie Dioden, Chips aus Siliciumwafern oder Sensoren, genannt. Die Vergußmassen müssen einer ganzen Reihe verschiedener Anforderungen entsprechen, die je nach dem Verwendungszweck in wechselnden Kombinationen auftreten. Die Vergußmassen sollten insbesondere
- eine gute Fließfähigkeit bei den üblichen Verarbeitungstemperaturen, d.h. bei Raumtemperatur und erhöhten Temperaturen bis zu etwa 80°C, aufweisen, um bei der Serienfertigung mit kurzen Taktzeiten verarbeitet werden zu können;
- thermisch hoch beanspruchbar sein, also eine möglichst hohe Glasübergangstemperatur aufweisen;
- auf den Substraten auch bei häufigem Temperaturwechsel gut haften, wozu ein niedriger thermischer Ausdehnungskoeffizient und eine hohe innere Flexibilität beitragen;
- gute dielektrische Eigenschaften besitzen, insbesondere geringe dielektrische Verluste und, zumindest bei Einsatz im Hochspannungsbereich, eine hohe elektrische Durchschlagsfestigkeit, wozu sie möglichst frei von ionischen Verunreinigungen sein und insbesondere niedrige Alkaligehalte aufweisen sollten;
- bei Umgebungstemperatur und gegebenenfalls bei erhöhten Betriebstemperaturen beständig gegen vielerlei Umwelteinflüsse sein, z.B. gegen oxidativen Abbau durch Luftsauerstoff, gegen Kraftstoffe, Öle und Salznebel; und
- sollten metallische Substrate wirksam gegen Korrosion schützen.

In US-A-3,849,187 werden Einkapselungsmittel für Transistoren und andere Halbleiterelemente beschrieben, die ein Epoxidharz sowie ein Amin, ein phenolisches Novolakharz oder ein Carbonsäureanhydrid als Härter und weiterhin einen Zusatz von 0,1 bis 5 Prozent eines Alkylalkoxysilans enthalten, das zwei oder drei niedere Alkoxygruppen aufweist und im Alkylrest eine Amino- oder Epoxidgruppe trägt. Das Silan soll die Isoliereigenschaften und die Dauerhaftigkeit des Einkapselungsmittels verbessern und eine Vorbehandlung oder Passivierung des Transistors oder Halbleiterelements überflüssig machen. Ein Nachteil dieser Einkapselungsmittel ist das schlechte Temperaturwechsel-Verhalten infolge ihrer höheren Sprödigkeit.

In DE-A1-32 29 558 werden Imprägniervergußmassen für elektrische Bauteile beschrieben, die aus einem Epoxidharz auf Basis von Bisphenol A und eines cycloaliphatischen Epoxids, einem modifizierten Dicarbonsäureanhydrid als Härter, einem Imidazol als Beschleuniger und Kreide als Füllstoff besteht. Diese Imprägniermassen sind nicht voll befriedigend, weil ihre Glasübergangstemperatur verhältnismäßige niedrig, ihr Wärmeausdehnungskoeffizient verhältnismäßig hoch und ihre Flexibilität wiederum verhältnismäßig niedrig ist. Die gehärteten Imprägniermassen neigen daher zu Schwund, Rißbildung und mangelnder Haftung.

In DE-C2-39 13 488 werden Vergußmassen für elektrische und elektronische Bauteile beschrieben, die ein niedrigviskoses cycloaliphatisches Epoxidharz der Formel 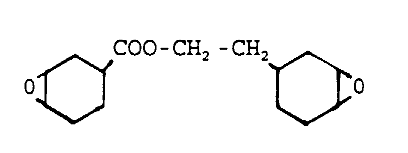 oder ein bestimmtes polyfunktionelles Epoxynovolakharz; Methylenendomethylentetrahydrophthalsäureanhydrid (auch Methylnadicsäureanhydrid genannt) als Härter; einen Härtungsbeschleuniger auf Imidazolbasis; amorphes, gegebenenfalls mit einem Epoxysilan vorbehandeltes Siliciumdioxid mit einer bestimmten Korngröße; einen Farbstoff sowie schließlich Glashohlkugeln als Füllstoff enthalten. Bei Verwendung für hochbeanspruchte Bauteile ist das thermische Langzeitverhalten der Imprägniermassen sowie das TW-Verhalten nicht ausreichend.

Diese bekannten Vergußmassen auf Basis von Epoxidharzen sind frei von Siliconverbindungen. In US-A-4 560 716 werden Epoxidharzmischungen offenbart, die (a) ein Epoxidharz, (b) einen Härter, (c) einen die Rostbildung verhindernden Zusatz von Dithiophosphorsäure, bestimmten Dithiophosphorsäurederivaten und/oder bestimmten Metallsalzen von Dithiocarbamidsäuren oder oxidierten Wachsen enthalten. Daneben können diese Epoxidharzmischungen (d) einen zweiten Zusatz aufweisen, der ein Alkylarylsilsesquioxan und/oder ein Organosiloxanpolymeres enthält. Für das Alkylarylsilsesquioxan wird die allgemeine Formel 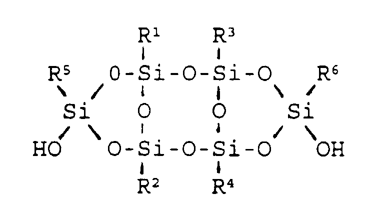 angegeben, in der R¹ bis R⁶ gleich oder verschieden sind und Alkyl-, Aryl-, Alkenyl- oder Aralkylreste bedeuten. Die Organosiloxanpolymeren sollen der allgemeinen Formel 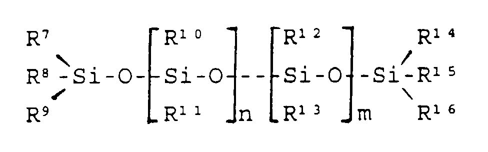 entsprechen, in der R⁷ bis R¹⁶ Alkyl-, Aryl-, Alkenyl-, Alkarylreste, Wasserstoff oder eine Hydroxylgruppe bezeichnen und n sowie m für 0 oder eine ganze Zahl von 1 oder höher stehen. Die genannte Druckschrift beschreibt somit Epoxidharzmischungen, die cyclische oder offenkettige Siliconharze, nicht jedoch elastomere Polyorganosiloxanverbindungen enthalten. Diese Epoxidharzmischungen werden zur Verwendung als Einkapselungsmaterialien für elektrische Bauteile empfohlen. Ihre die Rostbildung verhindernde Wirkung beruht darauf, daß die Zusatzstoffe, die nicht mit dem Epoxidharz reagieren, nach der Einkapselung auf die Oberfläche des eingekapselten Bauteils wandern und dort einen gegen Rost schützenden Film bilden. Die als fakultative Zusatzstoffe genannten siliciumorganischen Materialien vermindern zusätzlich den Verlust an elektrischen Isoliereigenschaften.

Aus DE-C2-36 34 084 ist ein modifiziertes, zu Duroplasten verarbeitbares Reaktionsharzgemisch bekannt, das als Reaktionsharz ein Epoxidharz enthalten kann und weiterhin dreidimensional vernetzte Polyorganosiloxankautschuke in Form von Teilchen mit einem Durchmesser von 0,01 bis 50 µm enthält, die auf ihrer Oberfläche reaktive Gruppen aufweisen, die, gegebenenfalls in Gegenwart von als Reaktionsvermittler dienenden Hilfsstoffen, mit dem Reaktionsharz chemisch reagieren. Diese Reaktionsharzgemische eignen sich nach der Druckschrift insbesondere für die Herstellung von bruch- und schlagzähen, gegebenenfalls ausgeformten duroplastischen Kunststoffen, faserverstärkten Kunststoffen, Isolierstoffen in der Elektrotechnik und Schichtpreßstoffen. Sie werden jedoch nicht als Vergußmassen für elektrotechnische oder elektronische Bauteile empfohlen.

In US-A-4,701,482 wird eine Epoxidharzzusammensetzung zum Einkapseln von Halbleiterbauelementen als Spritzgießmasse offenbart, die eine hohe Resistenz gegenüber Rißbildung aufweist. Die Zusammensetzung enthält neben einem thermisch aushärtbaren Epoxidharz und einem anorganischen Füllstoff eine Mischung bestehend aus einem Organopolysiloxan, dessen OH-Gruppe durch eine funktionelle Gruppe, wie beispielsweise einen glycidyl-, amino- oder mercapto-funktionellen Rest, substituiert wurde, und einem Copolymer, das selbst aus einem aromatischen Polymer und einem Organopolysiloxan besteht. Die Aushärtung der Spritzgießmasse erfolgt bei 180°C über 4h. Ihre Glasübergangstemperatur liegt bei 151°C bis 160°C. Nachteilig bei dieser Epoxidharzzusammensetzung ist die erforderliche, verfahrenstechnisch aufwendige Aufbereitung, die teilweise auch über Zugabe eines Lösungsmittels, das später wieder abgezogen werden muß, erfolgt. Im übrigen ist die hergestellte Masse nicht drucklos gießfähig und erfordert relativ lange Aushärtzeiten.

### Vorteile der Erfindung

Durch die Verwendung der härtbaren, Silicon-modifizierte Epoxidharze enthaltenden Epoxidharzgemische als Vergußmassen für elektrotechnische und elektronische Bauteile gemäß der vorliegenden Erfindung werden Vorteile erzielt, die einerseits verarbeitungstechnischer Natur sind und sich andererseits auf die Leistung bzw. die Eigenschaften der gehärteten Vergußmassen bzw. der betreffenden vergossenen Bauteile beziehen. Dies gilt besonders für die Verwendung als Vergußmasse zum Vergießen von elektronischen Bauteilen auf Basis von Halbleitern, wie Chips und Dioden, wobei es weniger auf die Bruch- oder Schlagzähigkeit, als vielmehr auf eine hohe innere Flexibilität ankommt.

Die modifizierten Epoxidharzgemische nach der Erfindung haben auch ohne Verdünnung mit Lösungsmitteln eine für eine rasche Verarbeitung hinreichend niedrige Viskosität, die bei den üblichen Verarbeitungstemperaturen von bis zu etwa 80°C im allgemeinen unterhalb von 50.000 mPa.s liegt. Sie eignen sich auch deshalb für die Fertigung in großen Serien, weil die Härtungszeiten kurz sind, d.h. je nach der Temperatur nur 10 bis 120 Minuten betragen können. Die Vergußmassen schützen nach dem Aushärten die verkapselten Bauteile hervorragend gegen Umwelteinflüsse, einschließlich Korrosion durch Feuchtigkeit. Letzteres ist bemerkenswert, weil die Vergußmassen nach der Erfindung keinen der Filmbildner enthalten müssen, die in den Einkapselungsmitteln nach US-A-4,560,716 die Rostbildung verhindern sollen, und die Siliconanteile der Silicon-modifizierten Epoxidharze chemisch an deren organische, Epoxidgruppen enthaltende Anteile gebunden, also immobilisiert sind. Diese Siliconanteile können also nicht auf dieselbe Weise wirksam werden wie die in den Einkapselungsmaterialien nach US-A-4,560,716 enthaltenen Organosiliciumverbindungen, die nicht mit dem Epoxidharz chemisch verbunden sind und daher auf die Oberfläche des verkapselten Bauelements wandern können, wo sie ihre korrosionsverhindernde Wirkung entfalten (Spalte 9, Zeilen 44 bis 60).

Die nach der Erfindung verwendeten, Silicon-modifizierte Epoxidharze enthaltenden Epoxidharzgemische weisen in gehärtetem Zustand hohe Glasübergangstemperaturen, beispielsweise von bis zu 220°C, auf und zeigen die erforderlichen dielektrischen Eigenschaften auch bei Temperaturen, die den Glasübergangstemperaturen nahekommen. Sie zeigen, insbesondere bei zweckentsprechender Auswahl der Art und der Menge des mineralischen Füllstoffs einen niedrigen thermischen Ausdehnungskoeffizienten, neigen daher bei Temperaturänderungen nicht oder nur in geringem Maße zu Schwund und Rißbildung und haften auch bei häufigem Temperaturwechsel hervorragend auf den Substraten. Die gehärteten Vergußmassen sind auch bei höheren Betriebstemperaturen über lange Zeiträume beständig gegen Umwelteinflüsse, zeigen also eine hervorragende Widerstandsfähigkeit gegenüber Luftsauerstoff und eine ebensolche Beständigkeit gegenüber Kraftstoffen, Ölen und Salznebeln. Die durch elastomere Siliconpolymere modifizierten Epoxidharzgemische werden besonders vorteilhaft als Vergußmassen für Dioden von Generatoren verwendet.

### Beschreibung der Erfindung

Die beschriebenen Vorteile werden erzielt durch die Verwendung der härtbaren, ein Silicon-modifiziertes Epoxidharz sowie einen mineralischen Füllstoff enthaltenden Epoxidharzgemische als Vergußmassen nach den Patentansprüchen 1 bis 12.

Es ist ein wesentliches Merkmal der Erfindung, daß die als Vergußmassen verwendeten Epoxidharzgemische ein Silicon-modifiziertes Epoxidharz enthalten, in dem organische, Epoxidgruppen enthaltende Anteile chemisch an Siliconanteile gebunden sind. Die Siliconanteile können elastomere Siliconpolymere in Form von Teilchen mit Teilchengrößen von 1 bis 25 µm, vorteilhaft von 1 bis 20 µm sein. Ein solches Silicon-modifiziertes Epoxidharz kann auch als ein teilchenförmiges elastomeres Polyorganosiloxan mit an der Oberflache chemisch gebundenen Epoxidgruppen bezeichnet werden. Dabei kann die chemische Bindung direkt durch Reaktion einer reaktiven Gruppe des Epoxidharzes mit auf der Oberfläche des Siliconteilchens vorhandenen reaktiven Gruppen bewirkt werden. Alternativ kann sie auch durch Brückenmoleküle geschaffen werden, deren reaktive Gruppen mit reaktiven Gruppen sowohl auf der Oberfläche der Siliconteilchen, als auch in den Epoxidharzmolekülen reagieren. Silicon-modifizierte Epoxid-harze der beschriebenen Art und deren Herstellung sind in der der zuvor erwähnten deutschen Patentschrift 36 34 084 beschrieben und von der Inhaberin des Patents, Hanse Chemie GmbH, erhältlich.

Bei einer anderen Variante der Silicon-modifizierten Epoxid-harze, in denen organische, Epoxidgruppen enthaltende Anteile innerhalb eines Moleküls chemisch an Siliconanteile gebunden sind, handelt es sich um Silicon-Blockcopolymere, die einen oder mehrere Polyorganosiloxan-Blöcke und einen oder mehrere organische Blöcke enthalten, die die Epoxidgruppen tragen und in geeigneter Weise, beispielsweise über Etherbrücken oder Carbonestergruppen, mit den Siliconblöcken chemisch verbunden sind. Beispiele hierfür sind Silicon-modifizierte Epoxidharze der Formel 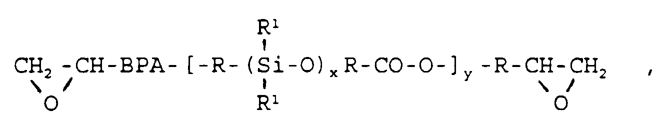 in der BPA einen Rest eines Bisphenol-A-Moleküls, R einen zweiwertigen organischen Rest, beispielsweise einen Ethylen- oder Propylenrest, und R¹ einen niederen Alkylrest, beispielsweise einen Methylrest, bezeichnet und x sowie y jeweils für eine ganze Zahl stehen. Silicon-Blockcopolymere der beschriebenen Art sind bekannt und ebenfalls von der Hanse Chemie GmbH erhältlich.

Neben den Silicon-modifizierten Epoxidharzen können zusätzlich andere, übliche Epoxidharze verwendet werden. Als solche eignen sich insbesondere die bekannten Epoxidharze auf Basis mehrwertiger aromatischer oder cycloaliphatischer Hydroxylverbindungen. Beispielsweise seien als Abkömmlinge von aromatischen Hydroxylverbindungen die Glycidylether von Bisphenol A oder Bisphenol F sowie von Phenol-Novolak-Harzen oder Kresol-Novolak-Harzen erwähnt. Brauchbare cycloaliphatische Epoxidharze sind z.B. bis-epoxidierter 1,2,3,6-Tetrahydrobenzoesäure-beta-1',2',3',6'-tetrahydrophenylethylester, Hexahydro-o-phthalsäure-bis-glycidylester usw. Auch aliphatische Epoxidharze, wie 1,4-Butandioldiglycidylether, sind zur Verwendung als zusätzliche Epoxid-Harze geeignet.

Der Gehalt der nach der Erfindung verwendeten Epoxidharzgemische an Siliconanteilen - sei es als teilchenförmige, chemisch an die Epoxidgruppen enthaltenden organischen Reste gebundene elastomere Siliconpolymere oder sei es in Form von Siloxanblöcken in Silicon-Blockcopolymeren - beträgt zweckmäßig 5 bis 40, insbesondere 10 bis 20 Gewichtsprozent, bezogen auf das Silicon-modifizierte Epoxidharz und gegebenenfalls das mitverwendete zusätzliche Epoxidharz. Bei geringeren als den genannten Siliconanteilen werden die günstigen Produkteigenschaften beeinträchtigt und vermindert sich insbesondere die erwünschte innere Flexibilität der gehärteten Epoxidharzgemische.

Ein weiteres wesentliches Merkmal der Epoxidharzgemische, die nach der vorliegenden Erfindung verwendet werden, ist ihr Gehalt an einem mineralischen Füllstoff. Durch die Wahl des mineralischen Füllstoffs lassen sich die Funktionseigenschaften der Epoxidgemische variieren. Bei der Verwendung zum Vergießen von elektronischen Bauteilen auf Basis von Halbleitern und insbesondere von Dioden hat sich amorphes Siliciumdioxid besonders bewährt. Dabei handelt es sich um entsprechend zerkleinerte elektrisch erschmolzene Kieselsäure. Andere geeignete mineralische Füllstoffe sind beispielsweise Quarzmehl, Aluminiumoxid und Dolomit (siehe z.B. Kunststoffe, 72 (1982), S. 228 ff.). Die mineralischen Füllstoffe können zur Verbesserung ihrer Benetzbarkeit durch das Epoxidharz in bekannter Weise silanisiert sein. Sie haben im allgemeinen einen mittleren Teilchendurchmesser von 3 bis 30 µm und können ein enges oder ein weites Korngrößenverteilungsspektrum aufweisen. Sie werden zweckmäßig in Mengen von 40 bis 75 Gew.-%, insbesondere von 50 bis 65 Gew.-%, bezogen auf das Gesamtgewicht von Epoxidharz(en) und gegebenenfalls Härter, zugesetzt.

Die Epoxidharzgemische können ohne zusätzlichen Härter nach einem ionischen Mechanismus selbsthärtend sein. Sie enthalten dann neben dem Epoxidharz einen Initiator, beispielsweise ein Sulfoniumsalz (vgl. EP-A2-0 379 464). In der Regel enthalten sie jedoch einen der bekannten Härter, die in einer kettenbildenden oder vernetzenden Reaktion mit dem Epoxidharz reagieren, beispielsweise eine mehrwertige Carbonsäure, ein Anhydrid einer mehrwertigen Carbonsäure oder ein mehrwertiges Amin. Besonders gut geeignete Härter sind die Dien-Additionsprodukte aus olefinisch ungesättigten Dicarbonsäureanhydriden, wie Maleinsäureanhydrid, und Dienen, insbesondere cyclischen Dienen, wie Cyclopentadien und Methylcyclopentadien. Mit diesen Carbonsäureanhydriden gehärtete Epoxidharzgemische zeigen besonders hohe Glasübergangstemperaturen.

Das Epoxidharz und der Härter werden zweckmäßig in etwa äquivalenten Mengen eingesetzt. Mit einem geringen, beispielsweise 10%-igen molaren Überschuß der einen oder anderen Komponente lassen sich die Funktionseigenschaften des Epoxidharzgemisches optimieren.

Die nach der vorliegenden Erfindung als Vergußmassen verwendeten Epoxidharzgemische können auch weitere, übliche Zusatzstoffe enthalten. Dazu zählen unter anderem Härtungsbeschleuniger, wie tertiäre Amine oder Imidazol, Pigmente, Ruß, Farbpasten, den Verlauf verbessernde Mittel, Sedimentationshemmer, Entschäumer und/oder Haftvermittler, die in den ublichen Mengen zugesetzt werden können.

Die nach der vorliegenden Erfindung verwendeten Epoxidharzgemische werden in üblicher Weise hergestellt und verarbeitet. Wenn die Gemische mit einem Härter gehärtet werden und nicht sofort verarbeitet werden sollen, empfiehlt es sich, sie als Zweikomponentensystem herzustellen und zu lagern. Dazu kann man einerseits das Silicon-modifizierte Epoxidharz, gegebenenfalls unmodifiziertes Epoxidharz und den Füllstoff (oder einen Teil davon) zu einer ersten Komponente und andererseits den Härter, gegebenenfalls einen Härtungsbeschleuniger, weiteren Füllstoff und/oder einen oder mehrere der genannten Zusatzstoffe zu einer zweiten Komponente mischen. Zur Verarbeitung werden dann die beiden Komponenten ihrerseits gemischt, bis ein homogenes, als Vergußmasse geeignetes Gemisch entstanden ist. Für alle Mischvorgänge eignen sich übliche Mischer, die eine hinreichende Scherwirkung auf die Bestandteile bzw. die Komponenten ausüben, beispielsweise statische Mischrohre, Durchlaufmischer oder Schwingmischer. Die Mischoperationen können bei Raumtemperatur oder bei mäßig erhöhter Temperatur, beispielsweise bis zu etwa 80°C, durchgeführt werden. Das gießbare Gemisch kann dann in üblicher Weise, beispielsweise in einem Gießverfahren zur Isolierung von Dioden verwendet werden. Je nach Auslegung der Anlage stehen hierfür eine oder mehrere Gießdüsen zur Verfügung.

### Beispiel

Eine Vergußmasse wird durch Mischen der folgenden Bestandteile in einem statischen Mischrohr bis zur Homogenität hergestellt:
- 75: Gewichtsteile Hexahydrophthalsäure-bis-glycidylester der Formel 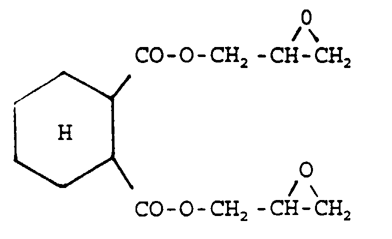 mit einem Epoxidgehalt von 6,5 bis 7,0 Aequiv./kg, einer Viskosität bei 25°C von 800 bis 1.050 mPa.s und einer Dichte bei 25°C von 1,20 bis 1,24 g/cm³ ;
- 25: Gewichtsteile Hexahydrophthalsäure-bis-glycidylester, der mit 40 Gew.-% Siliconteilchen mit einem mittleren Teilchendurchmesser von 10 µm modifiziert ist, hergestellt nach DE-A2-36 34 084;
- 105: Gewichtsteile Methylnadicsäureanhydrid als Härter;
- 1: Gewichtsteil Imidazol als Beschleuniger;
- 330: Gewichtsteile amorphes Quarzpulver mit einem mittleren Teilchendurchmesser von 20 µm.

Mit diesem Gemisch als Vergußmasse wurden Dioden für Generatoren vergossen. Die Dioden wurden zur Härtung der Vergußmasse eine Stunde auf 100°C und eine weitere Stunde auf 200°C erhitzt. Die gehärtete Vergußmasse zeigte die folgenden Eigenschaften:

| | |
|---|---|
| linearer Schwund | 0,02 %/K |
| Glasübergangstemperatur (Tg) | 210 - 215°C |
| Thermischer Ausdehnungskoeffizient | |
| - unterhalb Tg (10⁻⁶/K) | 25 - 30 |
| - oberhalb Tg (10⁻⁶/K) | 90 - 100 |
| Chlorid | < 10 ppm |
| Alkalimetalle | < 2 ppm |

## Patentansprüche

1. Verwendung eines härtbaren Epoxidharzgemisches, welches ein erstes Epoxidharz enthält, das eine chemisch gebundene lineare Organopolysiloxangruppe aufweist und ein zweites Epoxidharz auf der Basis von mehrwertigen aromatischen oder cycloaliphatischen Hydroxylverbindungen enthält, sowie einen Härter und einen mineralischen Füllstoff, wobei das erste Epoxidharz elastomerer Natur ist und zwischen der funktionellen Oxiran- und der linearen Organopolysiloxangruppe mindestens ein bisfunktionelles Brückenmolekül oder Brückenmolekülfragment enthält, als Vergußmasse für elektrotechnische oder elektronische Bauteile.

2. Verwendung nach Anspruch 1, dadurch gekennzeichnet, daß das bisfunktionalisierbare Brückenmolekül ausgewählt ist aus der Gruppe bestehend aus Bisphenol A, Bisphenol F, und das bisfunktionelle Brückenmolekülfragment ausgewählt ist aus der Gruppe bestehend aus -CH₂CH₂COO- und -CH₂CH₂CH₂COO-.

3. Verwendung nach Anspruch 1 und 2, dadurch gekennzeichnet, daß das weitere Epoxidharz ein cycloaliphatisches und/oder aliphatisches Epoxidharz ist.

4. Verwendung nach Anspruch 3, dadurch gekennzeichnet, daß das cycloaliphatische Epoxidharz Hexahydrophthalsäure-*bis*-glycidylester ist.

5. Verwendung nach Anspruch 1, dadurch gekennzeichnet, daß der mineralische Füllstoff amorphes Siliziumdioxid ist.

6. Verwendung nach Anspruch 1 und 5, dadurch gekennzeichnet, daß der Anteil des amorphen Siliziumdioxids 40-75 Gew.%, bezogen auf das härtbare Epoxidharzgemisch, beträgt.

7. Verwendung nach Anspruch 1, dadurch gekennzeichnet, daß der Härter ein Dien-Additionsprodukt aus einem olefinisch ungesättigten Dicarbonsäureanhydrid und einem cyclischen Dien ist.

8. Verwendung nach Anspruch 1, dadurch gekennzeichnet, daß das Epoxidharzgemisch zusätzlich einen Initiator für eine kationische Vernetzung des Epoxidharzes enthält.

9. Verwendung nach Anspruch 1, dadurch gekennzeichnet, daß das Epoxidharzgemisch weiterhin einen Härtungsbeschleuniger, Pigmente, Ruß, Farbpaste, Sedimentationshemmer, Entschäumer und/oder Haftvermittler als weitere(n) Zusatzstoff(e) enthält.

## Claims

1. Use of a curable epoxy resin mixture which comprises a first epoxy resin which has a chemically bonded linear organopolysiloxane group and comprises a second epoxy resin based on multifunctional aromatic or cycloaliphatic hydroxyl compounds, and also a curing agent and a mineral filler, where the first epoxy resin is elastomeric in nature and contains, between the functional oxirane group and the linear organopolysiloxane group, at least one bifunctional bridging molecule or bridging-molecule fragment, as a potting compound for components in electrical engineering or for electronic components.

2. Use according to Claim 1, characterized in that the bifunctional bridging molecule has been selected from the group consisting of bisphenol A and bisphenol F, and the bifunctional bridging-molecule fragment has been selected from the group consisting of -CH₂CH₂COO and -CH₂CH₂CH₂COO-.

3. Use according to Claim 1 or 2, characterized in that the other epoxy resin is a cycloaliphatic and/or aliphatic epoxy resin.

4. Use according to Claim 3, characterized in that the cycloaliphatic epoxy resin is bisglycidyl hexahydrophthalate.

5. Use according to Claim 1, characterized in that the mineral filler is amorphous silicon dioxide.

6. Use according to Claim 1 or 5, characterized in that the proportion of the amorphous silicon dioxide is from 40 to 75% by weight, based on the curable epoxy resin.

7. Use according to Claim 1, characterized in that the curing agent is a diene addition product made from an olefinically unsaturated dicarboxylic anhydride and from a cyclic diene.

8. Use according to Claim 1, characterized in that the epoxy resin mixture also comprises an initiator for cationic crosslinking of the epoxy resin.

9. Use according to Claim 1, characterized in that the epoxy resin mixture comprises, as other additive(s), moreover a curing accelerator, pigments, carbon black, colour paste, sedimentation inhibitor, antifoam and/or adhesion promoter.

## Revendications

1. Utilisation d'un mélange de résines époxy durcissable contenant une première résine époxy qui possède des groupes organosiloxane linéaires liés chimiquement et une deuxième résine époxy à base de composés hydroxylés plurifonctionnels aromatiques ou cycloaliphatiques, ainsi qu'un durcisseur et un produit de charge minéral,
dans lequel
la première résine époxyde est de nature élastomère et contient entre les groupes oxirane et organopolysiloxane linéaire fonctionnels, au moins une molécule de pontage bisfonctionnelle, ou un fragment de molécule de pontage, comme masse de scellement pour des éléments de construction électrotechniques ou électroniques.

2. Utilisation selon la revendication 1,
caractérisée en ce que
la molécule de pontage bisfonctionnalisable est choisie dans le groupe formé du bisphénol A, du bisphénol F et du fragment de molécule de pontage bisfonctionnelle consistant en CH₂CH₂COO et CH₂CH₂CH₂COO-.

3. Utilisation selon la revendication 1 et 2,
caractérisée en ce que
l'autre résine époxy est une résine époxy cycloaliphatique et/ou aliphatique.

4. Utilisation selon la revendication 3,
caractérisée en ce que
la résine époxy cycloaliphatique est un ester de bisglycidyle d'acide hexahydrophtalique.

5. Utilisation selon la revendication 1,
caractérisée en ce que
le produit de charge minéral est du dioxyde de silicium amorphe.

6. Utilisation selon la revendication 1 et la revendication 5,
caractérisée en ce que
le pourcentage de dioxyde de silicium amorphe s'élève à 40-75 % en poids, rapporté au mélange de résines époxy durcissable.

7. Utilisation selon la revendication 1,
caractérisée en ce que
le durcisseur est un produit d'addition diénique formé à partir d'un anhydride d'acide dicarboxylique non saturé éthyléniquement et d'un diène cyclique.

8. Utilisation selon la revendication 1,
caractérisée en ce que
le mélange de résines époxy renferme en supplément un promoteur pour une réticulation cationique de la résine époxy.

9. Utilisation selon la revendication 1,
caractérisée en ce que
le mélange de résines époxy renferme en outre un accélérateur de durcissement, des pigments, du noir de fumée, des pâtes de colorant, des inhibiteurs de sédimentation, des agents anti-mousse, et/ou des adjuvants d'adhésion, comme additif(s) supplémentaires(s).
